(19) **Europäisches Patentamt / European Patent Office / Office européen des brevets**

(11) **EP 4 560 925 A1**

(12) **EUROPEAN PATENT APPLICATION**
published in accordance with Art. 153(4) EPC

(43) Date of publication:
**28.05.2025 Bulletin 2025/22**

(21) Application number: **23842753.8**

(22) Date of filing: **23.06.2023**

(51) International Patent Classification (IPC):
*H04B 1/10* (2006.01)     *H02J 7/00* (2006.01)
*H01M 10/42* (2006.01)     *H01M 10/48* (2006.01)

(52) Cooperative Patent Classification (CPC):
**H01M 10/42; H01M 10/48; H02J 7/00; H04B 1/10**

(86) International application number:
**PCT/JP2023/023281**

(87) International publication number:
**WO 2024/018822 (25.01.2024 Gazette 2024/04)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:   **21.07.2022   JP 2022116645**

(71) Applicant: **Panasonic Intellectual Property
Management Co., Ltd.
Kadoma-shi, Osaka 571-0057 (JP)**

(72) Inventors:
• **ABE Yugo**
  **Kadoma-shi, Osaka 571-0057 (JP)**
• **KURANUKI Masaaki**
  **Kadoma-shi, Osaka 571-0057 (JP)**
• **HAMAMOTO Katsuaki**
  **Kadoma-shi, Osaka 571-0057 (JP)**

(74) Representative: **Novagraaf International SA
Chemin de l'Echo 3
1213 Onex, Geneva (CH)**

(54) **RECEPTION CIRCUIT, POWER STORAGE PACK, RECEPTION METHOD, RECEPTION PROGRAM, AND STORAGE MEDIUM IN WHICH RECEPTION PROGRAM IS DESCRIBED**

(57)     First resistor R1 is connected to a non-inverting input terminal of comparator CP. Second resistor R2 is connected to a feedback path between an output terminal and the non-inverting input terminal of comparator CP. Capacitor C1 is connected between a connection point that is between first resistor R1 and the non-inverting input terminal of comparator CP and a low-side fixed potential. A binary voltage that represents a plurality of bits of information is input to an inverting input terminal of comparator CP as an input signal. The input signal of the binary voltage is input to the non-inverting input terminal of comparator CP via a low-pass filter that includes first resistor R1 and capacitor C1.

## FIG. 7

EP 4 560 925 A1

**Description**

TECHNICAL FIELD

The present disclosure relates to a reception circuit that receives binary voltage representing a plurality of bits of information, a power storage pack, a reception method, and a reception program.

BACKGROUND ART

In recent years, electrically assisted bicycles have become increasingly popular. Removable and portable battery packs are used in electrically assisted bicycles. In order to eliminate terminals for communication lines from battery pack connectors, a system has been developed to transmit control signals wirelessly by including a wireless communication function in the battery packs and the electrically assisted bicycles.

When a plurality of electrically assisted bicycles are present within the range where wireless communication can be established with the battery pack of a vehicle, the battery pack may be erroneously controlled by another vehicle that is adjacent to the vehicle, and the safety and security of the entire system cannot be guaranteed. In particular, in rental services and sharing services, a plurality of electrically assisted bicycles are often parked in a single bicycle parking lot. In order to operate the entire system safely and securely, each electrically assisted bicycle needs to correctly identify the mounted battery pack.

Identification information could be superimposed on a power line with binary current (other than zero) or binary voltage (other than zero) while supplying power from the battery pack to the vehicle via the power line. The receiver compares the measured value of current or voltage with a threshold value, sets the measured value greater than or equal to the threshold value to 1 and sets the measured value less than the threshold value to 0, and receives the identification information.

However, variations in component characteristics and changes in current consumption may add offsets to the measured values of current or voltage, which may prevent the identification information from being received correctly. Factors that cause variations in the current or the voltage superimposed on the power line include both long-term and short-term factors. The long-term factors include individual differences in electronic components and aging. The long-term factors almost entirely depend on variations in the DC component. The short-term factors include unexpected variations in load current, such as intermittent operation of a microcontroller. The short-term factors are caused by variations in the AC component, and correspond to current or voltage variations in a single packet.

Patent Literature (PTL) 1 discloses a method for switching a current threshold by switching a load resistor using a switch according to the intensity of the communication current.

Citation List

Patent Literature

[PTL 1] International Publication No. WO18/173173

SUMMARY OF THE INVENTION

In the method disclosed in PTL 1, the number of switchable current thresholds depends on the number of load resistors and switches. Hence, in order to increase the number of switchable current thresholds, the circuit scale needs to be increased. The current threshold is switched between fixed values. In addition, it is difficult to address the short-term variation factors.

The present disclosure has been conceived in view of these circumstances. An object of the present disclosure is to provide a technique for reducing bit errors when binary voltage representing a plurality of bits of information is received.

In order to solve the problems described above, a reception circuit according to one aspect of the present disclosure includes: a comparator; a first resistor that is connected to a non-inverting input terminal of the comparator; a second resistor that is connected to a feedback path between an output terminal and the non-inverting input terminal of the comparator; and a capacitor that is connected between a connection point that is between the first resistor and the non-inverting input terminal of the comparator and a low-side fixed potential. A binary voltage that represents a plurality of bits of information is input to an inverting input terminal of the comparator as an input signal, and the input signal of the binary voltage is input to the non-inverting input terminal of the comparator via a low-pass filter that includes the first resistor and the capacitor.

Note that an arbitrary combination of the structural elements described above and those obtained by converting the expressions described in the present disclosure into devices, systems, methods, computer programs, recording media on which the computer programs are recorded, and the like are also effective as embodiments of the present disclosure.

According to the present disclosure, it is possible to reduce bit errors when binary voltage representing a plurality of bits of information is received.

BRIEF DESCRIPTION OF THE DRAWINGS

[FIG. 1] FIG. 1 illustrates an electrically assisted bicycle on which a battery pack according to an embodiment is mounted.

[FIG. 2] FIG. 2 is a diagram for describing an outline of Authentication Processing Example 1 of the battery pack mounted on a vehicle.

[FIG. 3] FIG. 3 illustrates Configuration Example 1 of the battery pack and the vehicle according to the embodiment.

[FIG. 4] FIG. 4 is a diagram for describing an outline of Authentication Processing Example 2 of the battery pack mounted on the vehicle.

[FIG. 5] FIG. 5 illustrates Configuration Example 2 of the battery pack and the vehicle according to the embodiment.

[FIG. 6A] FIG. 6A illustrates an example of transmission current and reception current superimposed on a power line.

[FIG. 6B] FIG. 6B illustrates an example of transmission current and reception current superimposed on a power line.

[FIG. 7] FIG. 7 illustrates a configuration example of a first ID detection circuit.

[FIG. 8] FIG. 8 illustrates an example of waveforms of reception current I input to the first ID detection circuit illustrated in FIG. 7 and threshold value Ith.

[FIG. 9] FIG. 9 illustrates a specific configuration example of the first ID detection circuit illustrated in FIG. 7.

[FIG. 10] FIG. 10 graphically illustrates relationships between input voltage Vin and high-side threshold value VthH and between input voltage Vin and low-side threshold value Vth when first resistor $R1 = 18.0$ k$\Omega$ and second resistor $R2 = 47.0$ k$\Omega$.

[FIG. 11A] FIG. 11A illustrates a simulation waveform of the first ID detection circuit illustrated in FIG. 9.

[FIG. 11B] FIG. 11B illustrates a simulation waveform of the first ID detection circuit illustrated in FIG. 9.

[FIG. 12] FIG. 12 illustrates simulation waveforms of input voltage Vin and threshold value Vth according to a comparative example.

DESCRIPTION OF EMBODIMENT

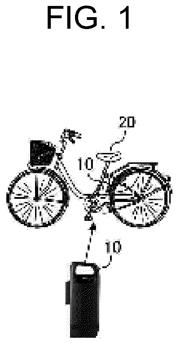

FIG. 1 illustrates an electrically assisted bicycle on which a battery pack according to an embodiment is mounted. Battery pack 10 is removable, portable, and replaceable, and can be mounted on the mounting slot of vehicle 20 or a charger (not illustrated). Hereinafter, in the present embodiment, an electrically assisted bicycle is assumed as vehicle 20.

Since replaceable battery pack 10 is frequently connected to and disconnected from the mounting slot of vehicle 20 or the charger, the connector portion of battery pack 10 is prone to progressive deterioration. In view of the above, in the present embodiment, battery pack 10 includes a wireless communication function to transmit control signals via wireless communication. This allows the terminal for the communication line to be eliminated from the connector of battery pack 10, leaving only the terminal for the power line.

Near field wireless communication is used for wireless communication between vehicle 20 and battery pack 10. Bluetooth (registered trademark), Wi-Fi (registered trademark), infrared communication, and the like can be used for the near field wireless communication. Hereinafter, it is assumed that Bluetooth Low Energy (BLE) is used as the near field wireless communication in the present embodiment.

The BLE is one of the extended standards of Bluetooth, and a low power consumption near field wireless communication standard using the 2.4 GHz band. The BLE is suitable for battery operation because the BLE consumes low power to such an extent that the battery pack can be driven for several years with a single button cell, thus, minimizing the impact on the remaining capacity of battery pack 10. In addition, many BLE communication modules have been shipped to the market, and therefore are available at low cost.

A radio wave coverage of the BLE is approximately 10 meters when a typical Class 2 device is used. Therefore, a state in which a plurality of vehicles 20 and a plurality of battery packs 10 are present within one communication range of BLE may occur. In such a case, radio wave interference may occur between vehicle systems, resulting in an unstable operation. Furthermore, vehicle 20 may be misconnect to another battery pack 10 that is other than battery pack 10 mounted on the vehicle. In such a case, unmounted battery pack 10 may be controlled incorrectly.

Therefore, a mechanism is required to ensure that battery pack 10 mounted on vehicle 20 and battery pack 10 of a communication partner of vehicle 20 are identical. In the present embodiment, identification information (ID) is used to check that battery pack 10 physically connected to vehicle 20 by wire and battery pack 10 connected by wireless communication are identical to each other. The identification information (ID) may be unique to each vehicle 20 or each battery pack 10, or may be temporal identification information. For example, a Bluetooth Device (BD) address or Medium Access Control (MAC) address may be used as unique identification information.

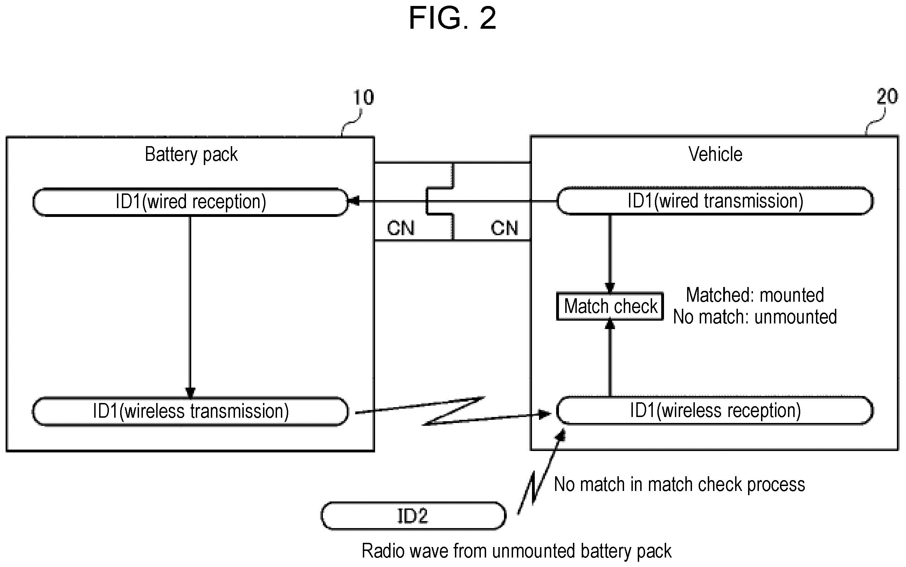

FIG. 2 is a diagram for describing an outline of Authentication Processing Example 1 of battery pack 10 mounted on vehicle 20. When the connector of battery pack 10 is connected to the connector of the mounting slot of vehicle 20, vehicle 20 transmits ID1 to battery pack 10 via wired communication. When battery pack 10 receives ID1 via wired communication, battery pack 10 transmits an advertisement packet (beacon packet) that includes received ID1 and battery pack ID of battery pack 10 via near field wireless communication. The advertisement packet is a signal for notifying nearby devices of the presence of battery pack 10 via near field wireless communication.

When receiving the advertisement packet, vehicle 20 checks ID1 included in the advertisement packet against ID1 transmitted to battery pack 10 via wired communication. When there is a match between these, vehicle 20 authenticates that the mounted battery pack 10 and the communication partner of vehicle 20 via near field wireless communication are identical. When there is no match between these, vehicle 20 determines that the mounted battery pack 10 and the communication partner of vehicle 20 via near field wireless communication are not identical, and does not authenticate battery pack 10 of the communication partner. For example, when vehicle 20 receives an advertisement packet that includes ID2, ID2 does not match ID1 transmitted to battery pack 10 via wired communication. Therefore, vehicle 20 does not authenticate battery pack 10 from which the advertisement packet that includes ID2 has been transmitted.

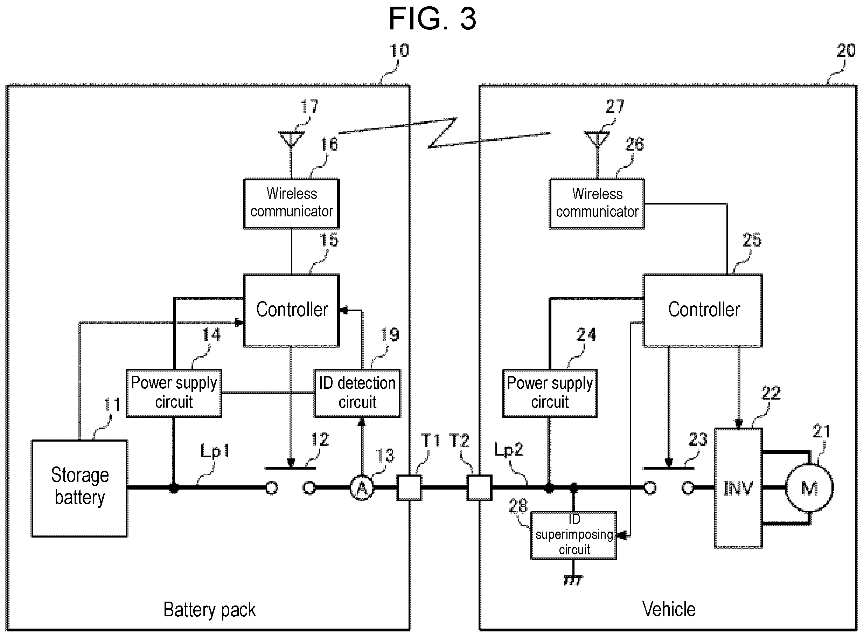

FIG. 3 illustrates Configuration Example 1 of battery pack 10 and vehicle 20 according to the embodiment. Configuration Example 1 illustrated in FIG. 3 corresponds to Authentication Processing Example 1. FIG. 3 illustrates the structural elements necessary for Authentication Processing Example 1, and the structural elements not related to Authentication Processing Example 1 are omitted as appropriate. FIG. 3 presumes a state in which battery pack 10 is mounted on vehicle 20.

Battery pack 10 includes storage battery 11, first relay 12, first current sensor 13, first power supply circuit 14, first controller 15, first wireless communicator 16, first antenna 17, first ID detection circuit 19, and power supply terminal T1. Vehicle 20 includes motor 21, inverter 22, second relay 23, second power supply circuit 24, second controller 25, second wireless communicator 26, second antenna 27, second ID superimposing circuit 28, and power receiving terminal T2. In a state where battery pack 10 is mounted on vehicle 20, power supply terminal T1 and power receiving terminal T2 are in physical contact with each other, and power line Lp1 in battery pack 10 and power line Lp2 in vehicle 20 are conducted to each other.

Storage battery 11 includes a plurality of cells connected in series or in series-parallel. Examples of the cells include lithium-ion battery cells, nickel-metal hydride battery cells, and lead-acid battery cells. Hereinafter, in the description, an example is assumed in which lithium-ion battery cells (nominal voltage: 3.6 V to 3.7 V) are used. The number of cells connected in series is determined according to the drive voltage of motor 21 of vehicle 20.

First relay 12 is disposed in power line Lp1 that connects storage battery 11 and power supply terminal T1. Instead of the relay, another type of switch, such as a semiconductor switch, may be used.

First current sensor 13 measures the current flowing in power line Lp1 in battery pack 10, and outputs the measured current to first ID detection circuit 19. First current sensor 13 includes, for example, a combination of a shunt resistor and an amplifier. The voltage across the shunt resistor disposed in power line Lp1 is amplified by the amplifier, so that first current sensor 13 outputs a voltage value corresponding to the current flowing in power line Lp1. A hall element or a CT sensor can be used instead of the shunt resistor.

First power supply circuit 14 is a DC/DC converter that steps down the voltage of storage battery 11 to generate supply voltage of first controller 15 (e.g., approximately 3.3 V to 5 V) and supply voltage of first ID detection circuit 19 (5 V in the specific example below). First power supply circuit 14 may include a switching regulator or a linear regulator.

First controller 15 is a microcontroller that controls the entire battery pack 10. First controller 15 monitors the state of storage battery 11 (specifically, the voltage, current, and temperature of each cell in storage battery 11). Based on the monitored data, first controller 15 estimates the state of charge (SOC), full charge capacity (FCC), and state of health (SOH) of each cell in storage battery 11. First controller 15 turns off first relay 12 to protect the cells in storage battery 11 when an overvoltage, undervoltage, overcurrent, high temperature anomaly or low temperature anomaly occurs in the cells.

First wireless communicator 16 executes near field wireless communication processing. In the present embodiment, first wireless communicator 16 includes a BLE module, and first antenna 17 includes a chip antenna or pattern antenna built into the BLE module. First wireless communicator 16 outputs data received via near field wireless communication to first controller 15, and transmits data input from first controller 15 via near field wireless communication.

In the present embodiment, vehicle 20 includes a three-phase AC motor as motor 21 for driving. Inverter 22 converts DC power supplied from battery pack 10 to AC power, and supplies the AC power to motor 21 during power operation. During regeneration operation, inverter 22 converts the AC power supplied from motor 21 to DC power, and supplies the DC power to battery pack 10. Motor 21 rotates according to the AC power supplied from inverter 22 during power operation. During regeneration operation, motor 21 converts the rotational energy from deceleration to AC power,

and supplies the AC power to inverter 22.

Second relay 23 is disposed in power line Lp2 that connects inverter 22 and power receiving terminal T2. Instead of the relay, another type of switch, such as a semiconductor switch, may be used.

Second power supply circuit 24 is a DC/DC converter that steps down the voltage supplied from storage battery 11 in battery pack 10 mounted on vehicle 20 to generate supply voltage (e.g., approximately 3.3 V to 5 V) of second controller 25. Second power supply circuit 24 may include a switching regulator or a linear regulator. In the present embodiment, vehicle 20 does not include batteries (e.g., lead-acid batteries) for generating control power supply. Therefore, it is necessary to generate the control power supply from the driving power supply supplied from storage battery 11 in the mounted battery pack 10.

Second controller 25 is a microcontroller that controls the entire vehicle 20. Second wireless communicator 26 executes near field wireless communication processing. In the present embodiment, second wireless communicator 26 includes a BLE module, and second antenna 27 includes a chip antenna or pattern antenna built into the BLE module. Second wireless communicator 26 outputs the data received via near field wireless communication to second controller 25, and transmits the data input from second controller 25 via near field wireless communication.

Second ID superimposing circuit 28 superimposes ID on the current flowing in power line Lp2. The ID is defined by a plurality of bits, each bit being represented by a binary current. When second controller 25 receives its power supply from storage battery 11 of battery pack 10, rather than from its own battery included in vehicle 20, it is not possible to assign the energization and de-energization of the current flowing from storage battery 11 to vehicle 20 to a binary current representing each bit of the ID. Therefore, the binary current representing each bit needs to be set to two different current values other than zero.

Second ID superimposing circuit 28 includes two loads with different resistance values, and one or more switches for selecting one of the two loads or for setting the two loads to non-conducting states. Second ID superimposing circuit 28 may also include a variable load that can be switched between two different resistance values, and one or more switches for switching the resistance value of the variable load or setting the variable load to a non-conducting state.

When second relay 23 is in an off state, the current flowing in power line Lp2 depends almost on the current consumed by second controller 25. When second relay 23 is off, second controller 25 sets ID to second ID superimposing circuit 28. Second ID superimposing circuit 28 superimposes the bit "1" of the ID on the current by setting the load with a smaller resistance value of two loads to a conducting state, and superimposes the bit "0" of the ID on the current by setting the load with a larger resistance value to a conducting state. This causes the value of the current drawn to vehicle 20 side to vary according to each bit of the ID.

First current sensor 13 of battery pack 10 measures the current flowing in power line Lp1, and outputs the measured current to first ID detection circuit 19. First ID detection circuit 19 detects the ID superimposed on the current flowing in power line Lp1 based on the voltage value corresponding to the current measured by first current sensor 13, and outputs the detected ID to first controller 15. An example of a specific configuration of first ID detection circuit 19 will be described later.

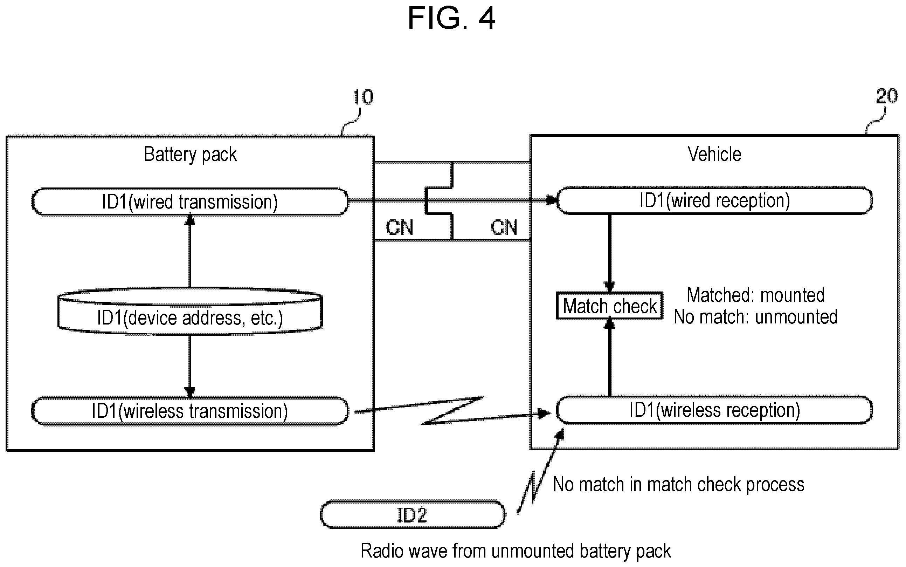

FIG. 4 is a diagram for describing an outline of Authentication Processing Example 2 of battery pack 10 mounted on vehicle 20. When the connector of battery pack 10 is connected to the connector of the mounting slot of vehicle 20, battery pack 10 transmits ID1 to vehicle 20 via wired communication. At the same time, battery pack 10 transmits an advertisement packet that includes ID1 via near field wireless communication.

When vehicle 20 receives the advertisement packet, vehicle 20 checks ID1 included in the advertisement packet against ID1 received via wired communication. When there is a match between these, vehicle 20 authenticates that the mounted battery pack 10 and the communication partner of vehicle 20 via the near field wireless communication are identical. When there is no match between these, vehicle 20 determines that the mounted battery pack 10 and the communication partner of vehicle 20 via the near field wireless communication are not identical, and does not authenticate battery pack 10 of the communication partner. For example, when vehicle 20 receives an advertisement packet that includes ID2, ID2 does not match ID1 received via wired communication. Therefore, vehicle 20 does not authenticate battery pack 10 from which the advertisement packet that includes ID2 has been transmitted.

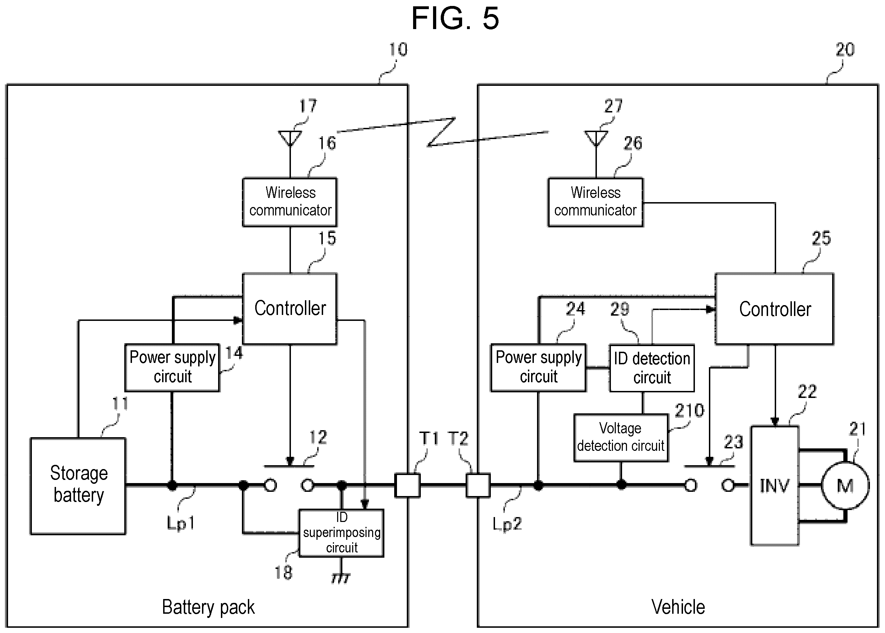

FIG. 5 illustrates Configuration Example 2 of battery pack 10 and vehicle 20 according to the embodiment. Configuration Example 2 illustrated in FIG. 5 corresponds to Authentication Processing Example 2. FIG. 5 illustrates the structural elements necessary for Authentication Processing Example 2, and the structural elements not related to Authentication Processing Example 2 are omitted as appropriate. In Configuration Example 1, ID is superimposed on the current flowing in the power line. In Configuration Example 2, ID is superimposed on the voltage of the power line.

In Configuration Example 2 illustrated in FIG. 5, compared to Configuration Example 1 illustrated in FIG. 3, first ID superimposing circuit 18 is included in battery pack 10, and second ID detection circuit 29 and voltage detection circuit 210 are included in vehicle 20. First ID superimposing circuit 18 includes, for example, an addition circuit that includes an operational amplifier. The operational amplifier uses the voltage of storage battery 11 as supply voltage, adds the ID voltage supplied from first controller 15 to the base voltage that is lower than the supply voltage, and outputs the voltage after addition to power line Lp1. This causes the value of the voltage supplied to vehicle 20 to vary according to each bit of the ID.

Voltage detection circuit 210 in vehicle 20 measures the voltage of power line Lp2, and outputs the measured voltage to second ID detection circuit 29. Voltage detection circuit 210 includes, for example, a resistor voltage divider circuit, and the divided voltage is input to second ID detection circuit 29. Second ID detection circuit 29 detects the ID superimposed on the voltage flowing in power line Lp2 based on the voltage value measured by voltage detection circuit 210, and outputs the detected ID to second controller 25.

In Configuration Example 1 illustrated in FIG. 3, ID is transmitted from vehicle 20 to battery pack 10, so that vehicle 20 serves as an identification information transmitting device and battery pack 10 serves as an identification information receiving device. In contrast, in Configuration Example 2 illustrated in FIG. 5, ID is transmitted from battery pack 10 to vehicle 20, so that battery pack 10 serves as an identification information transmitting device and vehicle 20 serves as an identification information receiving device. A description of an identification information receiving device will be given below based on Configuration Example 1 that employs the current superimposing method.

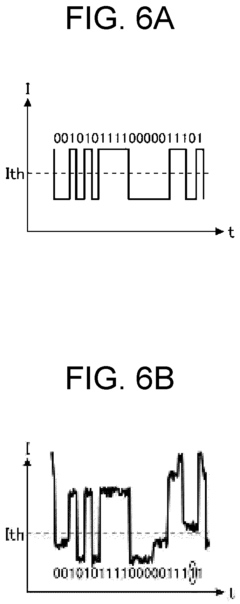

FIG. 6A and FIG. 6B each illustrate an example of transmission current and reception current superimposed on the power line. FIG. 6A illustrates an example of transmission current superimposed by the identification information transmitting device, and FIG. 6B illustrates an example of reception current detected by the identification information receiving device. The identification information receiving device determines bit "1" when current value I is greater than or equal to threshold value Ith, and determines bit "0" when current value I is less than threshold value Ith. As an example, threshold value Ith may be set to 50 mA, an assumed value of the low-level side of current value I may be set to 30 mA, and an assumed value of the high-level side of current value I may be set to 70 mA.

In this case, an offset may be added to current value I due to variations in component characteristics and changes in current consumption. Variations in component characteristics are caused by at least one of individual differences, temperature changes, and aging. Unexpected changes in current consumption of the identification information transmitting device (vehicle 20) occur, for example, when some kind of background processing or event processing (e.g., software update processing) is initiated in second controller 25 (microcontroller) during the authentication processing using second controller 25. Changes in current consumption of the identification information transmitting device (vehicle 20) can also be caused by changes in the configuration of the identification information transmitting device (vehicle 20), such as the illumination of light.

When the current consumption of the identification information transmitting device increases due to such changes in system conditions or system configuration, the current flowing in the power line increases. That is, an offset is added to the current flowing in the power line. The offset can cause errors in bit determination of the ID superimposed on the current flowing in the power line. In the examples illustrated in FIG. 6A and FIG. 6B, the ID superimposed on the current by the identification information transmitting device is "00101011110000011101", while the ID detected from the current by the identification information receiving device is "00101011110000011111". In such a manner, a bit error has occurred in the second least significant bit of the detected ID. The following describes a method for achieving stable communication by canceling the effects of the offset superimposed on the current and preventing ID bit determination errors.

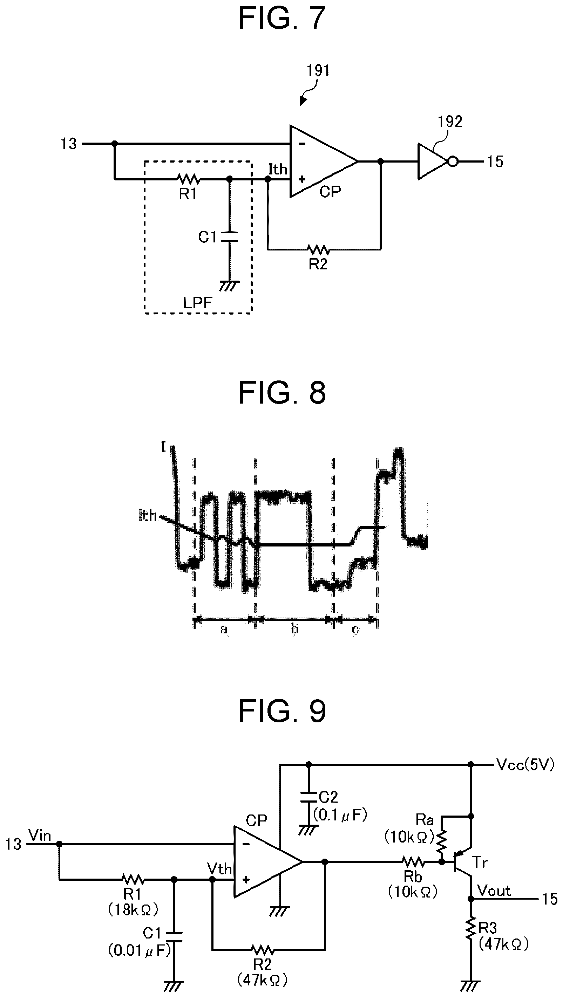

FIG. 7 illustrates a configuration example of first ID detection circuit 19. First ID detection circuit 19 includes hysteresis comparator 191 and inversion circuit 192. Hysteresis comparator 191 includes comparator CP, first resistor R1, second resistor R2, and first capacitor C1.

Comparator CP is an open collector comparator or an open drain comparator.

First resistor R1 is connected to the non-inverting input terminal of comparator CP. Second resistor R2 is connected to the feedback path between the output terminal and the non-inverting input terminal of comparator CP. First capacitor C1 is connected between the connection point that is between first resistor R1 and the non-inverting input terminal of comparator CP and the low-side fixed potential (which is the ground potential in the present embodiment).

Hysteresis comparator 191 is an inverting hysteresis comparator that includes Schmitt trigger characteristics by application of positive feedback. An input signal that indicates a voltage value corresponding to the current flowing in the power line is input to the inverting input terminal of comparator CP. The input signal includes binary voltage representing a plurality of bits of information. An ID defined by a plurality of bits is superimposed on the current flowing in the power line. The ID is represented in binary voltage and input to the inverting input terminal of comparator CP.

The input signal is input to the non-inverting input terminal of comparator CP via a low-pass filter that includes first resistor R1 and first capacitor C1. In other words, the value obtained by integrating the input signal is input to the non-inverting input terminal of comparator CP. In the present embodiment, the integrated value is used as threshold value Ith for determining whether the input signal is at a high level or at a low level.

Inverting hysteresis comparator 191 outputs a low level when the input signal exceeds threshold value Ith, and outputs a high level when the input signal falls below threshold value Ith. In hysteresis comparator 191, the threshold value when the output signal is at the high level and the threshold value when the output signal is at the low level are different values. The threshold value when the output signal is at the high level is a low-side threshold value and the threshold value when the output signal is at the low level is a high-side threshold value. The range between the low-side threshold value and the high-side threshold value is a dead zone where the output is not inverted. When the high-level input signal falls below low-side threshold value IthL, the output signal of hysteresis comparator 191 transitions from the low level to the high level. When the low-level input signal exceeds high level threshold value IthH, the output signal of hysteresis comparator 191 transitions from the high level to the low level.

Inversion circuit 192 inverts the logic of the signal input from hysteresis comparator 191, and outputs the inverted signal. Specifically, inversion circuit 192 outputs a low level when a high level is input from hysteresis comparator 191, and outputs a high level when a low level is input from hysteresis comparator 191.

The output signal of hysteresis comparator 191 may be directly input to the analog input port of first controller 15 (microcontroller) without including inversion circuit 192. In that case, the logic of the output signal of hysteresis comparator 191 is inverted within controller 15.

FIG. 8 illustrates an example of the waveforms of reception current I input to first ID detection circuit 19 illustrated in FIG. 7 and threshold value Ith. In the example illustrated in FIG. 8, unlike the examples illustrated in FIG. 6A and FIG. 6B, threshold value Ith changes dynamically in accordance with variations in reception current I. Threshold value Ith basically varies while being maintained at around the center of the amplitude of the high level and the low level of reception current I. During the period in which reception current I frequently changes between the high level and the low level, as indicated in period a, threshold value Ith is maintained at around the center of the amplitude of reception current I due to the action of the low-pass filter. As indicated in period b, during the period when reception current I remains either at the high level or at the low level, threshold value Ith is maintained at around the center of the amplitude of reception current I due to the action of the Schmitt trigger. When a variation occurs in reception current I, as indicated in period c, threshold value Ith follows the variations of reception current I and is maintained at around the center of the amplitude of reception current I after the variations due to the action of the low-pass filter and Schmitt trigger.

FIG. 9 illustrates a specific configuration example of first ID detection circuit 19 illustrated in FIG. 7. The high-side power supply terminal of comparator CP is connected to the high-side fixed potential (VCC = 5V in the example illustrated in FIG. 9), and the low-side power supply terminal of comparator CP is connected to the low-side fixed potential (ground potential in the example illustrated in FIG. 9). Second capacitor C2 is connected between the high-side fixed potential and the low-side fixed potential. Second capacitor C2 is a bypass capacitor for noise removal.

Inversion circuit 192 includes PNP transistor Tr, first pull-up resistor Ra, second pull-up resistor Rb, and third resistor R3. PNP transistor Tr and third resistor R3 are connected in series between the high-side fixed potential and the low-side fixed potential. PNP transistor Tr includes an emitter terminal that is connected to the high-side fixed potential, a collector terminal that is connected to third resistor R3, and a base terminal that is connected to the output terminal of comparator CP. The connection point between PNP transistor Tr and third resistor R3 is the output of first ID detection circuit 19.

First pull-up resistor Ra and second pull-up resistor Rb are connected in series between the high-side fixed potential and the output terminal of comparator CP. Specifically, first pull-up resistor Ra is connected between the emitter terminal and the base terminal of PNP transistor Tr, and second pull-up resistor Rb is connected between the output terminal of comparator CP and the base terminal of PNP transistor Tr. The bias resistor of PNP transistor Tr is used for first pull-up resistor Ra and second pull-up resistor Rb.

A digital transistor that includes two bias resistors may be used as PNP transistor Tr. The two bias resistors may be externally provided. Instead of the two bias resistors, another pull-up resistor may be connected between the high-side fixed potential and the output terminal of comparator CP.

A P-channel field-effect transistor (FET) may also be used in place of PNP transistor Tr. In that case, the P-channel FET includes a source terminal that is connected to the high-side fixed potential, a drain terminal that is connected to third resistor R3, and a gate terminal that is connected to the output terminal of comparator CP and first pull-up resistor Ra.

In general, high-side threshold value VthH and low-side threshold value VthL of the hysteresis comparator are defined by (Equation 1) and (Equation 2) below.

$$VthH = a \cdot (R2/R1) \cdot Vref + aVOH \ldots \text{(Equation 1)}$$

$$VthL = a \cdot (R2/R1) \cdot Vref + aVOL \ldots \text{(Equation 2)}$$

$$a = 1/(1+(R2/R1))$$

VOH: Output voltage level when comparator is at high level
VOL: Output voltage level when comparator is at low level

In the present embodiment, reference voltage Vref applied to first resistor R1 is input voltage Vin, so that (Equation 1) and (Equation 2) above are rewritten as (Equation 3) and (Equation 4) below.

$$VthH = a \cdot (R2/R1) \cdot Vin + aVOH \ldots \text{(Equation 3)}$$

$$VthL = a \cdot (R2/R1) \cdot Vin + aVOL \ldots \text{(Equation 4)}$$

Therefore, threshold value Vth, which is the voltage at the non-inverting input terminal of comparator CP, is defined by (Equation 5) below.

$$Vth = a \cdot (R2/R1) \cdot Vin + aVO \quad \ldots \text{(Equation 5)}$$

In such a manner, threshold value Vth varies depending on whether input voltage Vin and output voltage VO of comparator CP are at the high level or at the low level. When input voltage Vin is at the low level, threshold value Vth is shifted upward, and when input voltage Vin is at the high level, threshold value Vth is shifted downward, so that threshold value Vth is maintained at around the center of the amplitude of input voltage Vin.

In open collector comparator CP, when output voltage VO of comparator CP is at the high level, PNP transistor Tr is off, and output voltage Vout output from the connection point between the collector terminal of PNP transistor Tr and third resistor R3 is at the low level. In this state, current flows from power supply Vcc through the path of first pull-up resistor Ra, second pull-up resistor Rb, second resistor R2, and first resistor R1.

The current equation when output voltage Vout is at the low level is defined by (Equation 6) below.

$$(Vin - Vth)/R1 = (Vcc - Vth)/(R2 + Ra + Rb) \ldots \text{(Equation 6)}$$

On the other hand, when output voltage VO of comparator CP is at the low level, PNP transistor Tr is on, and output voltage Vout output from the connection point between the collector terminal of PNP transistor Tr and third resistor R3 is at the high level. In this state, current flows from the base terminal of PNP transistor Tr through comparator CP to the low-side fixed potential.

The current equation when output voltage Vout is at the high level is defined by (Equation 7) below.

$$(Vin - Vth)/R1 = (Vth - 0)/R2 \ldots \text{(Equation 7)}$$

Increased voltage ΔV+ of threshold value Vth when PNP transistor Tr is turned on is defined by (Equation 8) below.

$$\Delta V+ = (Ton/C1) \cdot ((Vcc - Vth)/(R2 + Ra + Rb)) \quad \ldots \text{(Equation 8)}$$

Ton: Turn-on time of PNP transistor Tr

Decreased voltage ΔV- of threshold value Vth when PNP transistor Tr is turned off is defined by (Equation 9) below.

$$\Delta V- = (Toff/C1) \cdot V/R \quad \ldots \text{(Equation 9)}$$

Toff: Turn-off time of PNP transistor Tr

The relationship between the constants of respective elements will be described below. The following design parameters are assumed in the following description.

Communication speed: 9600 bps = 4800 Hz
Range of input voltage Vin: 0 V to 5.0 V
High level of input voltage Vin: 3.0 V
Low level of input voltage Vin: 1.5 V
Variations of input voltage Vin due to load variations: ±0.5 V
High level of output voltage Vout: 4.0 V to 5.0 V
Low level of output voltage Vout: 0 V to 0.5 V

In the present embodiment, each parameter was set as follows based on the above design parameters.
Pull-up power supply (Vcc): 5.0 V
First pull-up resistor Ra: 10.0 kΩ
Second pull-up resistor Rb: 10.0 kΩ
First resistor R1: 18.0 kΩ
Second resistor R2: 47.0 kΩ

$$a = 1/(1 + (R2/R1)): 0.28$$

VOH: 4.9 V
VOL: 0.1 V

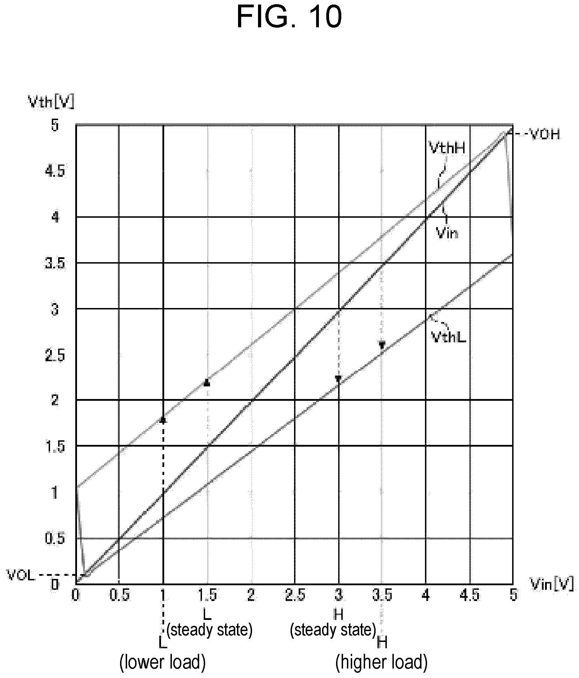

FIG. 10 graphically illustrates relationships between input voltage Vin and high-side threshold value VthH and between input voltage Vin and low-side threshold value Vth when first resistor R1 = 18.0 kΩ and second resistor R2 = 47.0 kΩ. In steady-state operation, high-side threshold value VthH when input voltage Vin is at the low level is required to be less than the high level of input voltage Vin, and low-side threshold value VthL when input voltage Vin is at the high level is required to be greater than the low level of input voltage Vin. In addition, it is desirable that high-side threshold value VthH when input voltage Vin is at the low level and low-side threshold value VthL when input voltage Vin is at the high level are values that are as close as possible.

In the example illustrated in FIG. 10, when the low level of input voltage Vin is 1.5V, high-side threshold value VthH is approximately 2.24 V. 2.24 V is less than 3.0 V that is the value when input voltage Vin is at the high level. When the high level of input voltage Vin is 3.0 V, low-side threshold value VthL is approximately 2.19 V. 2.19 V is greater than 1.5 V that is the value when input voltage Vin is at the low level.

At the time of load variations, with respect to the magnitude of the assumed load variations, it is necessary that input voltage Vin does not exceed output voltage level VOH at the time of the high level of comparator CP and does not fall below output voltage level VOL at the time of the low level of comparator CP.

In the example illustrated in FIG. 10, when the low level of input voltage Vin decreases by -0.5 V of the assumed load variations and reaches 1.0 V, input voltage Vin does not fall below 0.1 V that is output voltage level VOL at the time of the low level of comparator CP. On the other hand, when the high level of input voltage Vin increases by +0.5 V of the assumed load variations and reaches 3.5V, input voltage Vin does not exceed 4.9 V that is output voltage level VOH at the time of the high level of comparator CP.

Based on the above considerations, the ratio of the resistance value of second resistor R2 to the resistance value of first resistor R1 (R2/R1) is set to be in the range between 2 and 3. In the examples illustrated in FIG. 9 and FIG. 10, the ratio is 2.61. When the ratio is set to a value that significantly deviates from the range between 2 and 3, threshold value Vth in steady-state operation will significantly deviate from the center of the amplitude of input voltage Vin. Hence, an incorrect detection is likely to occur at the time of load variations.

The sum of the resistance value of first resistor R1 and the resistance value of second resistor R2 is set to at least three times the resistance value of the pull-up resistor (the total resistance value of first pull-up resistor Ra and second pull-up resistor Rb in the present embodiment). In the example illustrated in FIG. 9 and FIG. 10, the sum of the resistance value of first resistor R1 and the resistance value of second resistor R2 is 65 kΩ, and the resistance of the pull-up resistor is 20 kΩ, so that the sum of the resistance value of first resistor R1 and the resistance value of second resistor R2 is set to 3.3 times the resistance value of the pull-up resistor.

When the resistance value of the pull-up resistor is greater than the sum of the resistance value of first resistor R1 and the resistance value of second resistor R2, output voltage VO of comparator CP when output voltage Vout is at the low level is low, and PNP transistor Tr may fail turning off. By setting the resistance value of the pull-up resistor to at least three times the sum of the resistance value of first resistor R1 and the resistance value of second resistor R2, PNP transistor Tr can be driven normally.

The resistance value of first resistor R1 and the capacitance value of first capacitor C1 are set such that cutoff frequency fc, which is defined by the resistance value of first resistor R1 and the capacitance value of first capacitor C1, falls within the range from 1/10 to 1/5 of the frequency of input voltage Vin.

In the examples illustrated in FIG. 9 and FIG. 10, cutoff frequency fc of the low-pass filter is approximately 884 Hz which is within the range from 1/10 to 1/5 of 4800 Hz of input voltage Vin. By setting cutoff frequency fc of the low-pass filter to approximately 1/5 of the frequency of the input signal, the effects of the short-term current variations in one packet can be sufficiently eliminated.

However, when cut-off frequency fc of the low-pass filter is set too low, the followability of threshold value Vth is reduced, leading to a reduction in determination accuracy of input voltage Vin. In view of this, the lower limit of cutoff frequency fc is desirably set to approximately 1/10 of the frequency of the input signal.

In the examples illustrated in FIG. 9 and FIG. 10, the capacitance value of second capacitor C2 is set to 0.1 uF. The constant of a general bypass capacitor connected to the power supply terminal of an IC is used.

The resistance value of third resistor R3 is selected in view of the dark current flowing through third resistor R3 when output voltage Vout is at the high level for a long period of time. For example, the resistance value of third resistor R3 is set in the range from 10 kΩ to 100 kΩ. In the examples illustrated in FIG. 9 and FIG. 10, the resistance value of third resistor R3 is set to 47.0 kΩ.

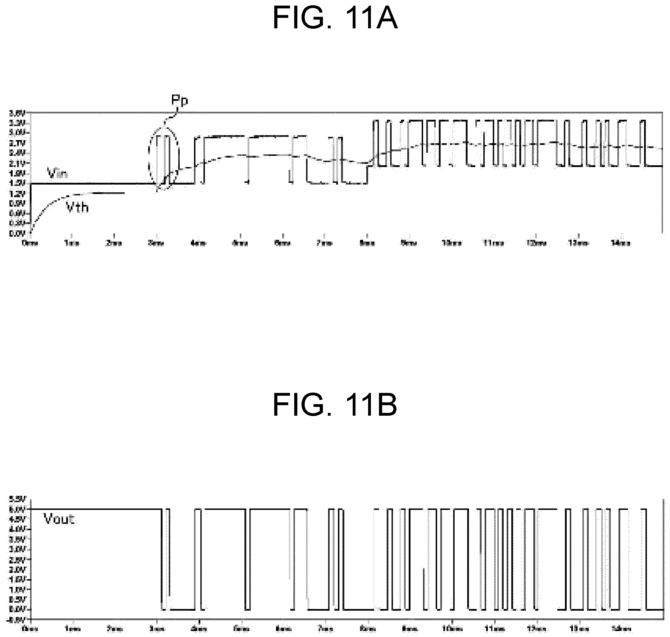

FIG. 11A and FIG. 11B illustrate the simulation waveforms of first ID detection circuit 19 illustrated in FIG. 9. FIG. 11A illustrates the simulation waveforms of input voltage Vin and threshold value Vth, and FIG. 11B illustrates the simulation waveform of output voltage Vout.

Immediately after comparator CP is turned on, threshold value Vth is less than 1.5 V that is the low level of input voltage Vin. This state is different from VthH (approximately 2.24 V) at low-level input illustrated in FIG. 10, which may result in an incorrect detection of the first bit of the ID that is the input signal.

In the present embodiment, before transmitting the ID, the identification information transmission device superimposes, on the power line, preset signal Pp for bringing threshold value Vth close to the center of the amplitude of the binary voltage representing the ID. The identification information receiving device receives preset signal Pp before receiving the ID that is the target input signal. In the example illustrated in FIG. 11A, a preset pulse that alternately repeats high and low levels is superimposed as preset signal Pp. The pattern of preset signal Pp and the time width between preset signal Pp and the ID signal can be set to optimal values by the designer based on experiments and simulations.

In the example illustrated in FIG. 11A, threshold value Vth is roughly around the center of the amplitude of input voltage Vin, and it is possible to correctly detect whether input voltage Vin is at the high level or at the low level based on threshold value Vth.

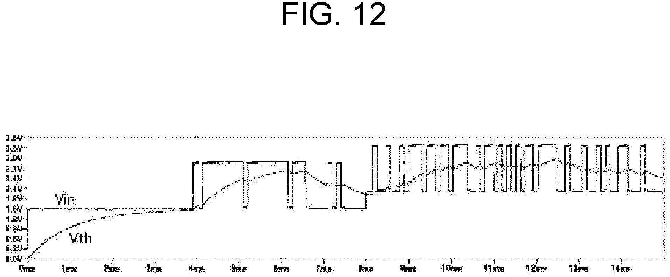

FIG. 12 illustrates the simulation waveforms of input voltage Vin and threshold value Vth according to a comparative example.

The comparative example is an example in which comparator CP to which no positive feedback is applied and which does not have Schmitt trigger characteristics is used. Due to the action of the low-pass filter, threshold value Vth basically tends to stay at around the center of the amplitude of input voltage Vin. However, in the section where input voltage Vin is continuously at the high level, threshold value Vth is attracted to the high level side, and in the section where input voltage Vin is continuously at the low level, threshold value Vth is attracted to the low level side.

Therefore, bit errors are likely to occur when significant load variations occur in the section where the high or low level of input voltage Vin continues. On the other hand, in the embodiment illustrated in FIG. 11A, threshold value Vth is maintained at around the center of the amplitude of input voltage Vin due to the action of the Schmitt trigger, even in the section where the high or low level of input voltage Vin continues. Therefore, bit errors due to variations in threshold value Vth are unlikely to occur.

As described above, first ID detection circuit 19 is operated by the power from storage battery 11. Considering that first ID detection circuit 19 is used only when battery pack 10 is mounted on vehicle 20, it is desirable to configure first ID detection circuit 19 so that the power supply to first ID detection circuit 19 can be cut off after a certain period of time (for example, 10 seconds) that is from when battery pack 10 is mounted until authentication is completed. In this case, the power consumption of storage battery 11 can be reduced.

The example, in which the ID superimposed on the current flowing in the power line is detected by hardware processing performed by first ID detection circuit 19, has been described above. In this regard, the ID can be detected by software processing by first controller 15 (microcontroller). In this case, first ID detection circuit 19 is omitted, and the input signal (input voltage Vin) corresponding to the current measured by first current sensor 13 is directly input to the analog input port of first controller 15 (microcontroller).

The A/D converter in first controller 15 (microcontroller) converts the input signal to a digital value at a sampling rate faster than the clock frequency corresponding to the communication speed of the ID (for example, a sampling rate of approximately 10 to 100 times the clock frequency). High-speed sampling is required for detailed observation of waveform transitions within a unit cycle of the input signal. The CPU in first controller 15 (microcontroller) integrates the digital input signals on which high-speed sampling has been performed, to calculate threshold value Vth. The CPU compares the calculated threshold value Vth with the input signal by Schmitt trigger operation, and determines 1 when the input signal is greater than or equal to threshold value Vth, and determines 0 when the input signal is less than threshold value Vth.

The ID detection process by software processing is effective when the communication speed of the ID is low.

On the other hand, when the communication speed of the ID is high, it is necessary to use high-performance first controller 15 (microcontroller). In addition, measures against heat generation are required. It is easier to change the time constant in the ID detection process by software processing than in the ID detection process by hardware processing.

As described above, in the present embodiment, the integral signal of the input signal based on the current on which ID has been superimposed is set as threshold value Vth, and the input signal based on the current is compared with threshold value Vth by Schmitt trigger operation, which automatically cancels the current variations. In this case, the current variations that dynamically follow the actual current variations can be canceled. More specifically, the DC component is extracted by a low-pass filter from the input signal based on the measured current to set threshold value Vth, thereby eliminating the effects of long-term current variations based on individual differences in electronic components and aging. In addition, by setting cutoff frequency fc of the low-pass filter in the range from 1/10 to 1/5 of the clock frequency corresponding to the communication speed of the ID, the effects of short-term current variations in a single packet can be sufficiently eliminated. Therefore, even when unexpected current variations occur during current communication, stable communication is possible. In such a manner, it is possible to reduce incorrect determination when detecting ID from the input signal based on current.

In addition, compared to the method for switching the current threshold by switching the load resistor according to the intensity of the communication current (see PTL 1), the detection value of the input signal based on current can be flexibly corrected and the correction range is wide. In contrast, the method according to PTL 1 does not allow fine switching of the current threshold, making it difficult to optimize the amount of correction to eliminate the effects of the current variations. In addition, the effects of the short-term current variations cannot be eliminated. In addition, it is necessary to detect the communication current and change the threshold value under the control of a microcontroller or the like, and there is no guarantee that the determination can be made after the threshold value is changed. In addition, a circuit is needed to change the threshold value. The ID detection method according to the present embodiment can be realized with a simple circuit or simple software, which is highly advantageous in actual use. It is not necessary to include load resistors and switches unlike the method according to PTL 1. In addition, the ID detection method according to the present embodiment is highly versatile and has a wide range of applications.

Each of first controller 15 and second controller 25 includes a microcomputer that mainly includes a central processing unit (CPU) and memory, for example. In other words, each of first controller 15 and second controller 25 is realized by a computer that includes a CPU and memory, and the computer functions as first controller 15 and second controller 25 when the CPU executes the program stored in the memory. The program is recorded in advance in the memory of controller 5 here, but may also be provided through telecommunication lines such as the Internet or recorded on a (non-transitory) recording medium such as a memory card.

The program may be recorded on a recording medium. By using the recording medium, for example, the program can be installed on the computer. Here, the recording medium on which the program is recorded may be a non-transitory recording medium. The non-transitory recording medium is not particularly limited, but may be, for example, a recording medium such as a CD-ROM.

The present disclosure has been described based on the embodiment. The embodiment is an example, and a person skilled in the art would easily understand that various modified examples combining the structural elements or processing in the embodiment can be made and that such modified examples are also in the scope of the present disclosure.

In the embodiment described above, the example has been described in which that battery pack 10 mounted on the mounting slot of vehicle 20 and battery pack 10 of the communication partner of vehicle 20 are identical is authenticated. In this regard, the ID detection method according to the embodiment described above can also be used to authenticate that battery pack 10 mounted on the mounting slot of a charger and battery pack 10 of the communication partner of the charger are identical. In this case, the charger may serve as the identification information transmitting device and battery pack 10 may serve as the identification information receiving device, or battery pack 10 may serve as the identification information transmitting device and the charger may serve as the identification information receiving device.

In the embodiment described above, the example has been described in which battery pack 10 that includes storage battery 11 is used. In this regard, a capacitor pack that includes capacitors, including electric double layer capacitor cells, lithium ion capacitor cells, etc., may be used. In the description of the present disclosure, battery packs and capacitor packs are collectively referred to as power storage packs.

While the present disclosure is suitable for vehicle 20 that does not include its own power supply, the present disclosure does not exclude application to vehicle 20 that includes its own power supply. Therefore, vehicles 20 are not limited to electrically assisted bicycles, but also include electric motorcycles (electric scooters), electric kick scooters, electric vehicles (including low-speed electric vehicles such as golf carts and land cars), and rail vehicles. The objects to which the power storage packs are mounted are not limited to vehicle 20, but include, for example, electric moving bodies such as electric vessels and multicopters (drones).

In the embodiment described above, the ID detection circuit has been described which receives binary voltage corresponding to identification information that is defined by a plurality of bits and superimposed on the current or voltage of the power line. In this regard, the circuit configuration illustrated in FIG. 7 or FIG. 9 above can also be applied when binary voltage representing a plurality of bits of information other than identification information is received. The circuits illustrated in FIG. 7 or FIG. 9 above that receive binary voltage representing a plurality of bits of information not limited to identification information is called a reception circuit. The reception circuit is a concept that encompasses the ID detection circuit. The binary voltage representing a plurality of bits of information received by the reception circuit may be binary voltage transmitted via a signal line or radio rather than the power line.

The reception circuit according to the present disclosure is effective for applications where the amplitude range of the received binary voltage (Vin) is different from the amplitude range of the output binary voltage (Vout). For example, it is effective for applications where the amplitude range of the received binary voltage (Vin) is far from zero. In such a manner, the reception circuit according to the present disclosure is capable of reducing bit errors when binary voltage representing a plurality of bits of information is received.

The embodiment may be specified by the following items.

[Item 1]

A reception circuit (19) including: a comparator (CP); a first resistor (R1) that is connected to a non-inverting input terminal of the comparator (CP); a second resistor (R2) that is connected to a feedback path between an output terminal and the non-inverting input terminal of the comparator (CP); and a capacitor (C1) that is connected between a connection point that is between the first resistor (R1) and the non-inverting input terminal of the comparator (CP) and a low-side fixed potential, wherein a binary voltage that represents a plurality of bits of information is input to an inverting input terminal of the comparator (CP) as an input signal, and the input signal of the binary voltage is input to the non-inverting input terminal of the comparator (CP) via a low-pass filter that includes the first resistor (R1) and the capacitor (C1).

With this, it is possible to reduce bit errors when binary voltage that represents a plurality of bits of information is received.

[Item 2]

The reception circuit (19) according to item 1, wherein a ratio of a resistance value of the second resistor (R2) to a resistance value of the first resistor (R1) is set to be in a range between two and three.

With this, it is possible to maintain the voltage (threshold value) of the non-inverting input terminal in a steady-state operation at around the center of the amplitude of the input signal of the binary voltage.

[Item 3]

The reception circuit (19) according to item 1, wherein the comparator (CP) is an open collector comparator (CP) or an open drain comparator (CP), and the reception circuit (19) further includes: a pull-up resistor (Ra, Rb) that is connected between the output terminal of the comparator (CP) and a high-side fixed potential; a PNP transistor (Tr) or a P-channel field-effect transistor (FET), the PNP transistor (Tr) including a base terminal that is connected to the output terminal of the comparator (CP) and an emitter terminal that is connected to the high-side fixed potential, the P-channel FET including a gate terminal that is connected to the output terminal of the comparator (CP) and a source terminal that is connected to the high-side fixed potential; and a third resistor (R3) that is connected between a collector terminal of the PNP transistor or a drain terminal of the P-channel FET and the low-side fixed potential.

With this, the high level and the low level of the output voltage can be easily matched to the supply voltage range of the subsequent circuit, while the output voltage of the comparator (CP) is logically inverted back to the logic of the input voltage.

[Item 4]

The reception circuit (19) according to item 3, wherein a sum of a resistance value of the first resistor (R1) and a resistance value of the second resistor (R2) is set to be at least three times a resistance value of the pull-up resistor (Ra, Rb).

With this, it is possible to drive the PNP transistor (Tr) or the P-channel FET normally.

[Item 5]

The reception circuit (19) according to item 3, wherein a ratio of a resistance value of the second resistor (R2) to a resistance value of the first resistor (R1) is set to be in a range between two and three, and a sum of the resistance value of the first resistor (R1) and the resistance value of the second resistor (R2) is set to be at least three times a resistance value of the pull-up resistor (Ra, Rb).

With this, it is possible to drive the PNP transistor (Tr) or the P-channel FET normally while maintaining the voltage (threshold value) of the non-inverting input terminal in a steady-state operation at around the center of the amplitude of the input signal of the binary voltage.

[Item 6]

The reception circuit (19) according to item 1, wherein a resistance value of the first resistor (R1) and a capacitance value of the capacitor (C1) are set such that a cut-off frequency defined by the resistance value of the first resistor (R1) and the capacitance value of the capacitor (C1) falls within a range from 1/10 to 1/5 of a frequency of the input signal.

With this, it is possible to sufficiently eliminate the effects of the short-term current variations.

[Item 7]

The reception circuit (19) according to item 1, wherein, before receiving a target input signal, the reception circuit (19) receives a preset signal for bringing a voltage of the non-inverting input terminal of the comparator (CP) close to a center of an amplitude of the target input signal.

With this, it is possible to prevent incorrect determinations from occurring immediately after the comparator (CP) is started.

[Item 8]

The reception circuit (19) according to any one of items 1 to 7, wherein the reception circuit (19) receives a binary voltage that represents identification information defined by a plurality of bits, the identification information being superimposed on a current or a voltage of a power line by an identification information transmitting device (20) connected to the reception circuit (19) via the power line.

With this, it is possible to reduce incorrect determination when detecting identification information superimposed on the current or voltage in the power line.

[Item 9]

A removable and portable power storage pack (10) including: the reception circuit (19) according to item 8.

With this, it is possible to realize a power storage pack (10) with a reduced incorrect determination in detecting identification information superimposed on the current or voltage in the power line.

[Item 10]

A receiving method including: integrating a binary voltage that represents a plurality of bits of information as an input signal; and setting the input signal integrated to a threshold value, comparing the threshold value with the input signal by a Schmitt trigger operation, and determining 1 when the input signal is greater than or equal to the threshold value and determining 0 when the input signal is less than the threshold value.

With this, it is possible to reduce bit errors when a binary voltage that represents a plurality of bits of information is received.

[Item 11]

A reception program for causing a computer to execute: integrating a binary voltage that represents a plurality of bits of information as an input signal; and setting the input signal integrated to a threshold value, comparing the threshold value with the input signal by a Schmitt trigger operation, and determining 1 when the input signal is greater than or equal to the threshold value and determining 0 when the input signal is less than the threshold value.

With this, it is possible to reduce bit errors when a binary voltage that represents a plurality of bits of information is received.

REFERENCE MARKS IN THE DRAWINGS

10      battery pack
20      vehicle
11      storage battery
12      first relay
13      first current sensor

| 14 | first power supply circuit |
|---|---|
| 15 | first controller |
| 16 | first wireless communicator |
| 17 | first antenna |
| 18 | first ID superimposing circuit |
| 19 | first ID detection circuit |
| 21 | motor |
| 22 | inverter |
| 23 | second relay |
| 24 | second power supply circuit |
| 25 | second controller |
| 26 | second wireless communicator |
| 27 | second antenna |
| 28 | second ID superimposing circuit |
| 29 | second ID detection circuit |
| 210 | voltage detection circuit |
| T1 | power supply terminal |
| T2 | power receiving terminal |
| Lp | power line |
| 191 | hysteresis comparator |
| 192 | inversion circuit |
| R1 | first resistor |
| R2 | second resistor |
| R3 | third resistor |
| Ra | first pull-up resistor |
| Rb | second pull-up resistor |
| C1 | first capacitor |
| C2 | second capacitor |
| CP | comparator |
| Tr | PNP transistor |

**Claims**

1. A reception circuit comprising:

   a comparator;
   a first resistor that is connected to a non-inverting input terminal of the comparator;
   a second resistor that is connected to a feedback path between an output terminal of the comparator and the non-inverting input terminal of the comparator; and
   a capacitor that is connected between (i) a connection point that is between the first resistor and the non-inverting input terminal of the comparator and (ii) a low-side fixed potential,
   wherein a binary voltage that represents a plurality of bits of information is input to an inverting input terminal of the comparator as an input signal, and
   the input signal of the binary voltage is input to the non-inverting input terminal of the comparator via a low-pass filter that includes the first resistor and the capacitor.

2. The reception circuit according to claim 1,
   wherein a ratio of a resistance value of the second resistor to a resistance value of the first resistor is set to be in a range between two and three.

3. The reception circuit according to claim 1,

   wherein the comparator is an open collector comparator or an open drain comparator, and
   the reception circuit further comprises:

      a pull-up resistor that is connected between the output terminal of the comparator and a high-side fixed potential;
      a PNP transistor or a P-channel field-effect transistor (FET), the PNP transistor including a base terminal that is connected to the output terminal of the comparator and an emitter terminal that is connected to the high-side fixed potential, the P-channel FET including a gate terminal that is connected to the output terminal of the comparator and a source terminal that is connected to the high-side fixed potential; and

a third resistor that is connected between a collector terminal of the PNP transistor or a drain terminal of the P-channel FET and the low-side fixed potential.

4. The reception circuit according to claim 3,
wherein a sum of a resistance value of the first resistor and a resistance value of the second resistor is set to be at least three times a resistance value of the pull-up resistor.

5. The reception circuit according to claim 3,

wherein a ratio of a resistance value of the second resistor to a resistance value of the first resistor is set to be in a range between two and three, and

a sum of the resistance value of the first resistor and the resistance value of the second resistor is set to be at least three times a resistance value of the pull-up resistor.

6. The reception circuit according to claim 1,
wherein a resistance value of the first resistor and a capacitance value of the capacitor are set such that a cut-off frequency defined by the resistance value of the first resistor and the capacitance value of the capacitor falls within a range from 1/10 to 1/5 of a frequency of the input signal.

7. The reception circuit according to claim 1,
wherein, before receiving a target input signal, the reception circuit receives a preset signal for bringing a voltage of the non-inverting input terminal of the comparator close to a center of an amplitude of the target input signal.

8. The reception circuit according to any one of claims 1 to 7,
wherein the reception circuit receives a binary voltage that represents identification information defined by a plurality of bits, the identification information being superimposed on a current or a voltage of a power line by an identification information transmitting device connected to the reception circuit via the power line.

9. A removable and portable power storage pack comprising:
the reception circuit according to claim 8.

10. A receiving method comprising:

integrating a binary voltage that represents a plurality of bits of information as an input signal; and
setting the input signal integrated to a threshold value, comparing the threshold value with the input signal by a Schmitt trigger operation, and determining one when the input signal is greater than or equal to the threshold value and determining zero when the input signal is less than the threshold value.

11. A reception program for causing a computer to execute:

integrating a binary voltage that represents a plurality of bits of information as an input signal; and
setting the input signal integrated to a threshold value, comparing the threshold value with the input signal by a Schmitt trigger operation, and determining one when the input signal is greater than or equal to the threshold value and determining zero when the input signal is less than the threshold value.

12. A non-transitory recording medium having recorded thereon a reception program for causing a computer to execute:

integrating a binary voltage that represents a plurality of bits of information as an input signal; and
setting the input signal integrated to a threshold value, comparing the threshold value with the input signal by a Schmitt trigger operation, and determining one when the input signal is greater than or equal to the threshold value and determining zero when the input signal is less than the threshold value.

# FIG. 1

# FIG. 2

**Battery pack** 10

ID1(wired reception)

ID1(wireless transmission)

CN    CN

**Vehicle** 20

ID1(wired transmission)

Match check

Matched: mounted
No match: unmounted

ID1(wireless reception)

No match in match check process

ID2

Radio wave from unmounted battery pack

EP 4 560 925 A1

# FIG. 3

EP 4 560 925 A1

# FIG. 4

**Battery pack** (10)

- ID1(wired transmission)
- ID1(device address, etc.)
- ID1(wireless transmission)

CN  CN

**Vehicle** (20)

- ID1(wired reception)
- Match check — Matched: mounted / No match: unmounted
- ID1(wireless reception)

No match in match check process

ID2

Radio wave from unmounted battery pack

EP 4 560 925 A1

# FIG. 5

**Vehicle** (20)

- Controller (25)
- Wireless communicator (26)
- (27)
- INV (22)
- M (21)
- (23)
- ID detection circuit (29)
- Voltage detection circuit (210)
- Power supply circuit (24)
- Lp2
- T1 T2

**Battery pack** (10)

- Wireless communicator (16)
- (17)
- Controller (15)
- Power supply circuit (14)
- Storage battery (11)
- (12)
- ID superimposing circuit (18)
- Lp1

# FIG. 6A

# FIG. 6B

# FIG. 7

# FIG. 8

# FIG. 9

# FIG. 10

# FIG. 11A

# FIG. 11B

# FIG. 12

## INTERNATIONAL SEARCH REPORT

International application No.

**PCT/JP2023/023281**

| A. | CLASSIFICATION OF SUBJECT MATTER |
|---|---|

*H04B 1/10*(2006.01)i; *H02J 7/00*(2006.01)i; *H01M 10/42*(2006.01)i; *H01M 10/48*(2006.01)i
FI:   H04B1/10 A; H01M10/48 P; H02J7/00 P; H01M10/42 P

According to International Patent Classification (IPC) or to both national classification and IPC

| B. | FIELDS SEARCHED |
|---|---|

Minimum documentation searched (classification system followed by classification symbols)

H04B1/10; H02J7/00; H01M10/42; H01M10/48

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | JP 2010-154094 A (TOSHIBA CORP) 08 July 2010 (2010-07-08) | 10-12 |
| Y | paragraphs [0014]-[0015], [0019], [0037], [0039], [0047], [0053], [0064], fig. 1-2, 10 | 1-9 |
| Y | JP 11-261658 A (FUJITSU DENSO LTD) 24 September 1999 (1999-09-24) paragraphs [0047]-[0048], fig. 6 | 1-9 |
| Y | JP 63-228915 A (KONTORAKUTAA TOOL & EQUIP TEKISUTORON INC) 22 September 1988 (1988-09-22) p. 5, lower right column, lines 14-15, p. 9, upper right column, lines 3-5, p. 9, lower left column, lines 5-7, fig. 1C-1D | 3-5 |
| Y | JP 2005-311657 A (MATSUSHITA ELECTRIC IND CO LTD) 04 November 2005 (2005-11-04) paragraph [0013], fig. 6 | 7 |
| Y | US 2021/0098833 A1 (POWER.GLOBAL, PBC) 01 April 2021 (2021-04-01) paragraphs [0009], [0021], [0023]-[0024], [0028], [0031], [0043], fig. 1-2, 4 | 8-9 |

☑ Further documents are listed in the continuation of Box C.     ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **06 July 2023** | **25 July 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

International application No.

**PCT/JP2023/023281**

**C.    DOCUMENTS CONSIDERED TO BE RELEVANT**

| Category* | Citation of document, with indication, where appropriate, of the relevant passages | Relevant to claim No. |
|---|---|---|
| A | MOC3011 データシート [オンライン], データシートサーチシステム, 1998 [retrieval date 06 July 2023], Internet <URL:https://www.alldatasheet.jp/datasheet-pdf/view/197004/TI/MOC3011.html>, <br> in particular, fig. 1, (MOC3011 datasheet [online]. Electronic Components Datasheet Search.) | 3-5 |
| A | LM339 Datasheet [online]. Electronic Components Datasheet Search. 2013 [retrieved on 06 July 2023], retrieved from the Internet<URL:https://pdf1.alldatasheet.net/datasheet-pdf/view/545566/TI/LM339.html>, <br> in particular, p. 3 | 3-5 |

Form PCT/ISA/210 (second sheet) (January 2015)

## INTERNATIONAL SEARCH REPORT
### Information on patent family members

International application No.

**PCT/JP2023/023281**

| Patent document cited in search report | | | Publication date (day/month/year) | Patent family member(s) | Publication date (day/month/year) |
|---|---|---|---|---|---|
| JP | 2010-154094 | A | 08 July 2010 | US 2010/0158157 A1 paragraphs [0026]-[0027], [0031], [0049], [0051], [0059], [0065], fig. 1-2, 10 | |
| JP | 11-261658 | A | 24 September 1999 | (Family: none) | |
| JP | 63-228915 | A | 22 September 1988 | US 4823057 A column 4, lines 5-6, column 7, lines 20-21, column 7, lines 38-39, fig. 1C-1D GB 2201850 A | |
| JP | 2005-311657 | A | 04 November 2005 | (Family: none) | |
| US | 2021/0098833 | A1 | 01 April 2021 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 18173173 A